# NEUE EUROPÄISCHE PATENTSCHRIFT

(11) **EP 3 345 217 B2**
(45) Veröffentlichungstag und Bekanntmachung des Hinweises auf die Entscheidung über den Einspruch: **30.08.2023**
(45) Hinweis auf die Patenterteilung: 05.08.2020
(21) Anmeldenummer: 16750792.0
(22) Anmeldetag: 08.08.2016
(51) Int. Cl.: H01L 23/373, H01L 23/473

(54) **KÜHLVORRICHTUNG, VERFAHREN ZUR HERSTELLUNG EINER KÜHLVORRICHTUNG UND LEISTUNGSSCHALTUNG**
COOLING DEVICE, METHOD FOR PRODUCING A COOLING DEVICE AND POWER CIRCUIT
DISPOSITIF DE REFROIDISSEMENT, PROCÉDÉ DE FABRICATION D'UN DISPOSITIF DE REFROIDISSEMENT ET CIRCUIT DE PUISSANCE

(30) Priorität: 03.09.2015 DE 102015216887
(43) Veröffentlichungstag der Anmeldung: 11.07.2018
(73) Patentinhaber: Vitesco Technologies GmbH, 93055 Regensburg (DE)
(72) Erfinder: SMIT, Arnoud, 90482 Nürnberg (DE); SCHMID, Thomas, 93051 Regensburg (DE); KELLER, Lars, 94330 Aiterhofen (DE); RITTSTIEG, Soeren, 93073 Neutraubllng (DE)
(74) Vertreter: Vitesco Technologies
(86) Internationale Anmeldenummer: PCT/EP2016/068861
(87) Internationale Veröffentlichungsnummer: WO 2017/036739

(56) Entgegenhaltungen:
- EP-A1- 1 696 526
- WO-A1-2016/005065
- DE-A1-102012 107 570
- DE-A1-102013 208 350

## Beschreibung

Die Erfindung betrifft eine Kühlvorrichtung, ein Verfahren zur Herstellung der Kühlvorrichtung und eine Leistungsschaltung, die mit einer Kühlvorrichtung ausgestattet ist. Insbesondere bei Automobilanwendungen werden elektrische oder elektronische Schaltungen bzw. Leistungshalbleiter oder andere elektronische oder elektrische Komponenten verwendet, deren Verlustwärme im Betrieb durch Kühlkörper abgeführt werden muss. Üblicherweise sind die Kühlkörper aus Aluminium wegen der guten Wärmeleitungseigenschaften, während die Schaltung mittels kupferbasierten Leiterplatte oder vergleichbaren Trägern ausgebildet ist. Um eine gute Wärmeableitung zu gewährleisten, sind Kühlkanäle in den Aluminiumkühlkörpern vorgesehen.

Die Offenlegungsschrift WO 2016/005065 A1 beschreibt eine Kühlvorrichtung, die einen Aluminiumkühlkörper und mindestens ein Nickelblech aufweist. Das Nickelblech ist mittels einer Lotschicht mit dem Aluminiumkühlkörper verbunden. Die Kühlvorrichtung weist eine Montagefläche zur Montage und zum Wärmeaustausch auf, die von der dem Aluminiumkühlkörper abgewandten Seite des Nickelblechs gebildet wird.

Die Schrift EP 1 696 526 A1 ist weiterer relevanter Stand der Technik.

Allerdings ist die Herstellung der Kühlkanäle in dem Aluminiumkühlkörper mit Aufwand verbunden, während Strangpressverfahren zur Ausbildung der Kühlkanäle eine Aluminiumzusammensetzung erfordern, deren Lötverhalten nicht optimal ist.

Es ist daher eine Aufgabe der Erfindung, eine Möglichkeit aufzuzeigen, mit der sich gekühlte Schaltungen auf einfache Weise herstellen lassen.

### Offenbarung der Erfindung

Diese Aufgabe wird erfüllt durch den Gegenstand der unabhängigen Ansprüche. Vorteilhafte Ausführungsformen ergeben sich mit den Merkmalen der abhängigen Ansprüche sowie anhand der vorliegenden Beschreibung.

Es wurde erkannt, dass Aluminiumkühlkörper auf einfache Weise und mit herkömmlichen Mitteln hergestellt werden können durch einen geschichteten Aufbau. Dadurch können Aluminiumbleche mit beliebiger Zusammensetzung verwendet werden. Durch Stanzen oder Fräsen können die Kühlkanäle sehr günstig und präzise erstellt werden. Der Stapelaufbau ermöglicht eine einfache Herstellung, indem abwechselnd mindestens ein Aluminiumblech mit Ausnehmungen (etwa durch Stanzen erzeugt) und Aluminiumbleche ohne Ausnehmungen gestapelt werden und miteinander verbunden werden. Das Verbinden der Aluminiumbleche kann durch einen Lötprozess geschehen, bei dem insbesondere weitere Komponenten wie ein Kupferblech oder ein Träger mit Kupferoberfläche mit dem Aluminiumblech (über eine Nickelschicht) verbunden wird, während gleichzeitig die Aluminiumbleche untereinander verbunden werden. Mit einer Lötmasse, die vor dem Stapeln aufgebracht wird, können diese Verbindungen hergestellt werden, indem diese etwa in einem Ofen aufgeschmolzen wird.

Gleichermaßen bietet die vom Kühlkörper abgewandte Seite des Blechstücks gute Löteigenschaften zur Montage von Kupfer, insbesondere durch die Nickelschicht, oder, allgemein, durch eine Lotvermittlungsschicht. Es wird daher auch ein Übergang zwischen unterschiedlichen Materialien (Kupfer und Aluminium) ermöglicht durch die Lotvermittlungsschicht, die beispielsweise als Nickel- oder Nickellegierungsschicht ausgebildet ist.

Es wird daher eine Kühlvorrichtung beschrieben, die einen Aluminiumkühlkörper und mindestens eine Lotvermittlungsschicht aufweist. Die Kühlvorrichtung ist zur Montage an eine Schaltung, insbesondere an eine Kupferschicht eines Schaltungsaufbaus, eingerichtet. Hierbei bildet die Lotvermittlungsschicht die (flächige) Wärmeübertragungsschnittstelle in Form einer Befestigungsfläche, auf der die Kupferschicht befestigt wird. Die mindestens eine Lotvermittlungsschicht ist stoffschlüssig und unmittelbar auf dem auf Aluminiumkühlkörper aufgebracht. Die mindestens eine Lotvermittlungsschicht ist dabei auf dem Aluminiumkühlkörper aufgedampft oder mittels galvanischer Abscheidung aufgebracht.

Die Kühlvorrichtung weist eine Befestigungsfläche zur Befestigung und zur Wärmeaufnahme auf, die die Funktion einer Wärmeübertragungsschnittstelle hat. Die Befestigungsfläche wird von einer Seite der Lotvermittlungsschicht ausgebildet. Diese Seite ist dem Aluminiumkühlkörper (und somit auch der Lotschicht zwischen Blechstück und Kühlkörper abgewandt. Diese Seite ist im Wesentlichen eben, kann jedoch auch an den Verlauf der anzubringenden Leiterplatte angepasst sein. Die Dicke der Lotvermittlungsschicht ist vorzugsweise an jeder Stelle der Schicht im Wesentlichen (d.h. mit einer Toleranz von nicht mehr als +/- 10% oder +/- 5%) gleich.

An dem Kühlkörper können ein oder mehrere Lotvermittlungsschichten befestigt sein. Es können mehrere Lotvermittlungsschichten direkt oder mit seitlichem Abstand zueinander an der Oberfläche des Kühlkörpers angeordnet sein. Es können mehrere Lotvermittlungsschichten an der gleichen, an unterschiedlichen oder an entgegengesetzten Seiten des Kühlkörpers vorgesehen sein. Insbesondere kann an (zwei) entgegengesetzten (vorzugsweise zueinander parallelen) Seiten des Kühlkörpers jeweils eine Lotvermittlungsschicht oder jeweils mehrere Lotvermittlungsschichten befestigt sein. Wie bereits bemerkt, ist das mindestens eine Lotvermittlungsschicht mittels einer stoffschlüssigen Verbindung durch Aufdampfen oder galvanisches Aufbringen auf dem Kühlkörperbefestigt. Insbesondere ist der Kühlkörper beidseitig mit zumindest einer Lotvermittlungsschicht versehen, um beidseitig Leiterplatten bzw. Schaltungen anbringen zu können.

Der Kühlkörper ist insbesondere flach und vorzugsweise im Wesentlichen quaderförmig. Der Kühlkörper kann Kühlfinger aufweisen, um Wärme an der Außenseite des Kühlkörpers und insbesondere an den Kühlfingern an ein umgebendes Wärmemedium (Luft) abzugeben. Der Kühlkörper weist zumindest einen Kühlkanal auf, der sich durch den Kühlkörper hindurch erstreckt, um Wärme an ein Wärmemedium (Flüssigkeit, insbesondere Öl oder Wasser) abzugeben, dass durch den Kühlkanal strömt.

Der Aluminiumkühlkörper ist aus mehreren Aluminiumblechen ausgebildet sein. Diese sind übereinander gestapelt. Ferner sind diese untereinander verbunden, insbesondere mittels einer Lotschicht, vorzugsweise einer Hartlotschicht. Zumindest ein Aluminiumblech weist Ausnehmungen auf. Das zumindest eine Aluminiumblech, das Ausnehmungen aufweist, ist beidseitig von zwei weiteren der Aluminiumbleche abgedeckt oder ist einseitig von dem Aluminiumblech und auf der anderen Seite von dem Blechstück abgedeckt. Die Ausnehmungen bilden einen Kühlkanal. Die Ausnehmungen erstrecken sich durch die gesamte Dicke des Aluminiumblechs oder nur durch einen Teil der gesamten Dicke des betreffenden Aluminiumblechs. Die Ausnehmung ist etwa in Form einer Nut. Die Ausnehmung führt bis zur Kante des Aluminiumblechs. Die Ausnehmung kann einen mäandernden Längsverlauf haben, wobei sich der Längsverlauf der Ausnehmung in eine und vorzugsweise zwei verschiedene Längserstreckungsrichtungen des Aluminiumblechs erstreckt. Die Ausnehmungen erstrecken sich daher vorzugsweise flächig. Die Ausnehmungen können in eine oder zwei Richtungen gemäß einem Raster ausgebildet sein. Die Ausnehmungen sind beispielsweise gestanzt oder gefräst oder auch gegossen. Die Aluminiumbleche sind insbesondere mittels Lotschichten miteinander verbunden. Die Lotschichten dichten die Aluminiumbleche gegeneinander ab.

Zwischen den Aluminiumblechen kann auch ein anderes Dichtelement vorgesehen sein (eine Lage abdichtenden, elastischen Materials wie etwa Silikon), wobei die Aluminiumbleche mittels Befestigungselemente miteinander verbunden sind, etwa eine Schraubverbindung, die sich durch die Aluminiumbleche erstreckt. Eines der Aluminiumbleche (insbesondere ein äußeres und/oder ein inneres) kann zudem flächige oder stabförmige Kühlfinnen aufweisen, die vorzugsweise in den Kühlkanal hineinragen. Eine Ausgestaltung mit stabförmigen Kühlfinnen wird auch als "Pin Fin"-Struktur bezeichnet, wobei die Kühlfinnen flächig (und vorzugsweise gleichmäßig) verteilt sind. Die Kühlfinnen erstrecken sich insbesondere im Inneren des Aluminiumkühlkörpers, d.h. in den zumindest einen Kühlkanal hinein, und können somit auch (in funktioneller Hinsicht) als Turbulatoren betrachtet werden.

Die Aluminiumbleche sind insbesondere gewalzte Aluminiumbleche. Diese sind die mittels Hartlot verlötbar. Der Kühlkörper und insbesondere die Aluminiumbleche haben vorzugsweise einen Schmelzpunkt von mindestens 590°C, wobei als Hartlot (zur Verbindung der Aluminiumbleche und/oder zur Befestigung des Nickel-Blechstücks, d.h. als Lotschicht) vorzugsweise Aluminium mit 8 - 15 % Massenanteil Silizium verwendet wird. Das Hartlot hat vorzugsweise eine Gießtemperatur von 670 - 740° C und ein Erstarrungsintervall von 570 - 590 °C. Es kann insbesondere AlSi12 als Hartlot verwendet werden. Als Hartlot eignen sich alle Al-Legierungen mit einem Silizium-Masseanteil von 7-13%. Zudem kann das Schmelzintervall des Hartlots von 575°C-615°C betragen.

Insbesondere haben der Kühlkörper und insbesondere die Aluminiumbleche einen Magnesiumanteil von weniger als 2 % Massenanteil, wodurch eine gute Benetzbarkeit (mit Lotmaterial) erreicht wird. Der Kühlkörper und insbesondere die Aluminiumbleche weisen einen Massenanteil von mindestens 70% Aluminium auf, um die Korrosionsbeständigkeit zu gewährleisten. Es können gewalzte (oder auch gegossene) Aluminiumbleche verwendet werden, unter anderem auch AlMg5Si2Mn. Die Schmelzuntergrenze der Aluminiumbleche beträgt in diesem Fall beispielsweise 594 °C. Falls der Aluminiumkörper nicht als Aluminiumblechstapel ausgebildet ist, kann dieser aus dem Material sein, aus dem die hier genannten Aluminiumbleche sind. Die vorgehenden Angaben betreffen daher gleichermaßen Aluminiumbleche und Aluminiumkühlkörper.

Die Begriffe "Aluminiumbleche" und "Aluminiumkühlkörper" weisen den Wortbestandteil "Aluminium" auf, wodurch angegeben wird, dass der Bestandteil vorwiegend Aluminium ist. Daher wird durch die Verwendung des Wortbestandteils "Aluminium" nicht auf einen Aluminiumanteil von 100% (Massenanteil) hingewiesen, sondern es kann sich um eine Legierung handeln, die vorwiegend aus Aluminium besteht, wobei wie erwähnt Zusätze nicht ausgeschlossen sind.

Die mindestens eine Lotvermittlungsschicht kann insbesondere eine Nickelschicht sein. Die mindestens eine Nickelschicht hat einen Massenanteil von Nickel von mindestens 70%, 85% oder auch von mindestens 95%, 98% oder 99% Nickel. Die Wärmeleitfähigkeit der Lotvermittlungsschicht beträgt vorzugsweise mindestens 70, 75 und besonders bevorzugt mindestens 85 oder 90 W/m * K.

Die Lotvermittlungsschicht kann eine Dicke von etwa 5 - 150 µm, insbesondere von 10 - 100 µm oder 20 - 50 µm aufweisen. Die Lotvermittlungsschicht ist nicht dicker als 150 µm und insbesondere nicht dicker als 100 µm, vorzugsweise nicht dicker als 50 oder 30 µm. Insbesondere wird die Lotvermittlungsschicht aufgebracht, bevor die Aluminiumbleche miteinander verbunden werden oder nachdem die Aluminiumbleche miteinander verbunden werden. Das Aufbringen der Lotvermittlungsschicht kann daher ein Schritt sein, der von dem Schritt des Verbindens der Aluminiumbleche untereinander getrennt ist.

In dem Kühlkörper können Kühlkanäle vorgesehen sein, die einen freien Innenquerschnitt aufweisen, oder in denen Turbulatoren eingebracht sind. Die Turbulatoren sind körperlich eigenständige Körper (etwa ein gefaltetes Blechstück), die mit der Innenwand des Kühlkanals verbunden sind, oder werden durch seitliche Ausnehmungen gebildet, oder werden durch Körperabschnitte gebildet, die in den Kanal hineinragen.

Ferner wird ein Verfahren zur Herstellung einer hier beschriebenen Kühlvorrichtung dargelegt. Im Rahmen des Verfahrens wird als beispielhafte Art und Weise der Verbindung der Aluminiumbleche Lötmasse auf eine Verbindungsfläche mindestens eines der Aluminiumbleche aufgebracht, etwa durch Drucken oder Aufwalzen, insbesondere durch Aufbringen oder Einlegen eines "Preforms" als Blech oder Folie, die die Lötmasse (insbesondere die Hartlötmasse innerhalb der Kühlvorrichtung) bildet. Die Aluminiumbleche werden gestapelt. Insbesondere werden die bereits mit Lötmasse versehenen Aluminiumbleche gestapelt oder die Aluminiumbleche werden alternierend mit der als Blech oder Folie ausgebildeten Lötmasse gestapelt. Die Lötmasse wird geschmolzen, um zumindest eine Lotschicht zwischen den Aluminiumblechen auszubilden. Dies wird beispielsweise ausgeführt, indem die Aluminiumbleche zusammen mit der Lötmasse erwärmt werden, etwa in einem Ofen. Der Ofen kann evakuiert sein oder kann im Innenraum eine Stickstoffatmosphäre aufweisen. Dadurch wird der Aluminiumkühlkörper als gestapelte Aluminiumblechstruktur erzeugt. Es kann Flussmittel verwendet werden, insbesondere als Zusatz zu der Lötmasse.

Die mindestens eine Lotvermittlungsschicht wird vor oder nach dem Verbinden der Aluminiumbleche aufgebracht, insbesondere vor oder nach dem Schmelzen der Lötmasse und gegebenenfalls vor oder nach dem Aufbringen der Lötmasse und/oder vor oder nach dem Stapeln der Aluminiumbleche.

Wie erwähnt ist das Verbinden der Aluminiumbleche mittels Lötmasse eine Möglichkeit von mehreren. Insbesondere kann auch geklebt werden oder es kann eine kraft- oder formschlüssige Verbindung mittels einer Klammer, einer Schraubverbindung oder ähnlichem hergestellt werden, um so die Aluminiumbleche untereinander zu verbinden.

Vor dem Stapeln kann zumindest eines der Aluminiumbleche gestanzt werden. Durch das Stanzen werden die Ausnehmungen gebildet, die den Kühlkanal bilden, der durch benachbarte Bleche oder Blechstücke abgeschlossen wird. Dieses Aluminiumblech kann im Rahmen des Stapelns zwischen zwei Aluminiumbleche oder gegebenenfalls zwischen einem Aluminiumbleche und dem Lotvermittlungsschicht (als Folie ausgebildet) eingefügt werden. Durch das Stapeln wird mittels der umgebenden Aluminiumbleche wird ein Kühlkanal ausgebildet. Durch das Stanzen werden die Ausnehmungen erzeugt, die zusammen mit den benachbarten Komponenten den mindestens einen Kühlkanal ausbilden. Im Rahmen des Stapelns kann ferner ein Turbulator (als eigenständiger Körper) in die Ausnehmung eingelegt und/oder dort befestigt werden. Hierbei kann zwischen dem Turbulator und dem angrenzenden Aluminiumblech Lötmasse eingebracht werden, so dass gegebenenfalls zusammen mit der Lötmasse zwischen den Aluminiumblechen und einem der Aluminiumbleche auch die Lötmasse zwischen dem Turbulator und dem angrenzenden Blech oder Blechstück aufgeschmolzen wird, um eine Lotschicht zu bilden. Dies kann kombiniert sein mit dem Aufschmelzen der Lötmasse zwischen der Lotvermittlungsschicht, sofern diese als Folie ausgebildet ist.

Im Rahmen des Verfahren zur Herstellung einer Kühlvorrichtung werden die Aluminiumbleche zur Ausbildung eines Aluminiumkühlkörpers gestapelt. Von den gestapelten Aluminiumblechen weist mindestens eines Ausnehmungen zu Ausbildung eines Kühlkanals auf.

Es werden die gestapelten Aluminiumbleche (20, 22, 24) miteinander zur Ausbildung des Aluminiumkühlkörpers verbunden. Das Verbinden kann etwa mittels Herstellen einer kraftschlüssigen oder formschlüssigen Verbindung geschehen, etwa durch Herstellen einer Schraubverbindung oder einer durch das Einklemmen von Kanten der Aluminiumbleche mittels einer Klammer, oder durch Verlöten der Aluminiumbleche. Beim Herstellen einer kraftschlüssigen oder formschlüssigen Verbindung kann vorgesehen werden, dass Dichtmasse wie Silikon oder vorzugsweise elastische Dichtkörper zwischen die Aluminiumbleche zur fluiddichten Verbindung der Aluminiumbleche untereinander eingebracht wird bzw. werden. Die Dichtmasse bzw. die Dichtkörper begrenzen den Kühlkanal.

Das Herstellen einer Lötverbindung zwischen den Aluminiumblechen ist daher optional und kann allgemein als mechanisches (und vorzugsweise fluiddichtes) Verbinden der gestapelten Aluminiumbleche angesehen werden.

Ferner wird die Lotvermittlungsschicht auf zumindest einem der Aluminiumbleche (24) angeordnet, das eine Außenseite des Aluminiumkühlkörpers (26) bildet. Dies kann ausgeführt werden durch unmittelbares stoffschlüssiges Aufbringen auf zumindest eines der Aluminiumbleche vor oder nach den Schritten des Stapelns und/oder des Verbindens.

Das Verbinden der gestapelten Aluminiumbleche kann umgesetzt werden durch Anbringen einer Schraubverbindung, die sich durch alle Aluminiumbleche erstreckt, oder durch Anbringen einer Klammer, die Kanten aller Aluminiumbleche umgreift. Alternativ kann gelötet werden, wobei die gestapelten Aluminiumbleche untereinander verbunden werden durch Aufbringen von Lötmasse auf eine Verbindungsfläche von mindestens einen Aluminiumblech, vorzugsweise vor dem Schritt des Stapelns.

Dann kann die Lötmasse zum Ausbilden zumindest einer Lotschicht zwischen den Aluminiumblechen aufgeschmolzen werden, indem die Aluminiumbleche zusammen mit der Lötmasse erwärmt werden. Dadurch wird der Aluminiumkühlkörper als gestapelte Aluminiumblechstruktur erzeugt.

In einem nachfolgenden Schritt kann mittels Weichlöten eine Leiterplatte oder ein anderer Träger mit Kupferleitschicht (oder auch nur eine Kupferleitschicht selbst) auf die Lotvermittlungsschicht aufgelötet werden. Die Temperatur ist hierbei unter dem Schmelzpunkt der vorangehend genannten Lötmasse.

Es wird ferner eine Leistungsschaltung mit einer wie hier erwähnten Kühlvorrichtung mit Aluminiumkühlkörper (aus gestapelten Blechen) und Lotvermittlungsschicht beschrieben, die ferner eine Leiterplatte aufweist. Die Leiterplatte ist beidseitig mit einer Leiterschicht versehen, insbesondere mit einer Kupfer-Leiterschicht. Die Leiterschicht und somit auch die Leiterplatte sind über eine Lotschicht (vorzugsweise Weichlot) mit der Lotvermittlungsschicht verbunden, insbesondere mit der Befestigungsfläche, welche von der Lotvermittlungsschicht ausgebildet wird. Die Leistungsschaltung weist ferner mindestens einen Halbleiter oder ein anderes elektrisches oder elektronisches Bauteil auf, der bzw. das auf der Seite der Leiterplatte auf der Leiterplatte montiert ist, die der Lotvermittlungsschicht abgewandt ist (d.h. auf der entgegengesetzten Leiterschicht). Die Lotschicht zwischen Leiterplatte und Befestigungsfläche bzw. zwischen Bauteil und Leiterplatte ist insbesondere aus Weichlot. Es kann Sn-basiertes Weichlot verwendet werden, vorzugsweise mit Ag-Zusatz, insbesondere Weichlot der Gruppe SnAg3,5, alternativ mit den Abwandlungen SnAg3Cu0,5 und Sn95,75Ag3,5Cu0,75.

Der Halbleiter kann ein Leistungshalbleiter in Form eines ungehäusten Halbleiters sein. Dieser ist mittels einer Weichlotschicht auf der Leiterplatte befestigt. Der Halbleiter (bzw. das Bauteil) kann im gleichen Schritt auf der Leiterplatte aufgelötet werden, in dem auch die Leiterplatte auf die Kühlvorrichtung (bzw. auf den Aluminiumkühlkörper bzw. auf die Befestigungsfläche / die Lotvermittlungsschicht) aufgelötet wird, indem die betreffende (Weich-)Lötmasse in einem Ofen (zusammen mit der Kühlvorrichtung, der Leiterplatte und dem Halbleiter/ dem Bauteil) erwärmt wird. In dem Ofen wird dabei eine Temperatur vorgesehen, die über dem Schmelzpunkt der Lötmasse zwischen Bauteil und Leiterplatte und der Lötmasse zwischen der Leiterplatte und dem Kühlkörper liegt, und die unter dem Schmelzpunkt der Lötmasse bzw. der Lotschichten liegt, die sich innerhalb der Kühlvorrichtung befinden.

Die Leistungsschaltung bildet insbesondere eine Elektromotor-Leistungsansteuerung eines Fahrzeugs, einen Spannungs- oder Strom-Leistungswandler in einem Fahrzeugbordnetz oder eine Wechselrichter- oder Gleichrichterschaltung. Die Leistungsschaltung ist vorzugsweise mehrphasig ausgelegt, insbesondere dreiphasig. Als Leistungsschaltung werden insbesondere Schaltungen bezeichnet, die eine Stromtragfähigkeit für Ströme von mindestens 50 A, 100 A, 200 A oder 500 A aufweisen.

Als Leiterplatte werden insbesondere "Direct Copper Bonded"-Leiterplatten verwendet, wobei auch gedruckte Leiterplatten mit Kupferkaschierung möglich sind. Zudem können als Leiterplatten Substrate verwendet werden, bei denen die Leiterschicht zunächst als einzelnes Blech strukturiert wird, wobei sich etwa durch Stanzen einzelne Leiterbahnen bzw. die Verbindungsstruktur ergeben, und danach diese Verbindungsstruktur mit dem Substrat verbunden wird, etwa durch Umspritzen der Verbindungsstruktur mit dem Material des (elektrisch isolierenden) Substrats.

### Kurzbeschreibung der Zeichnung

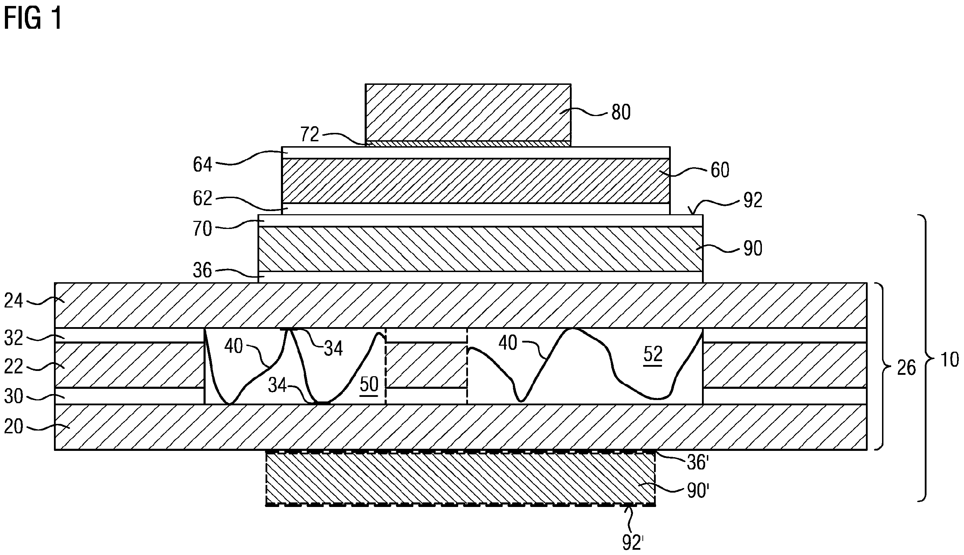

Die Figur 1 zweigt eine Leistungsschaltung und einen der Leistungsschaltung zugehörigen Kühlkörper im Querschnitt

### Detaillierte Beschreibung der Zeichnung

Figur 1 zeigt im Querschnitt eine Kühlvorrichtung 10, die mehrere, übereinander gestapelte Aluminiumbleche 20, 22, 24 umfasst. Die Aluminiumbleche (einschließlich zugehöriger Elemente wie Lotschichten, Zulauf, Ablauf, Turbulatoren, Befestigungselemente, ...) bilden einen Aluminiumkühlkörper. Die Aluminiumbleche sind bündig übereinander gestapelt. Das Aluminiumblech 22, welches zwischen den Aluminiumblechen 20 und 24 liegt, weist Ausnehmungen 50, 52 auf, die einen Kühlkanal ausbilden. Dieser Kühlkanal reicht bis zu einer Außenfläche des Kühlkörpers 10, insbesondere bis zu einer Kante, die etwa versetzt zur Zeichenebene liegt (und daher nicht dargestellt ist). Es können ein Zulauf bzw. ein Ablauf vorgesehen sein, die sich an den Enden des Kühlkanals befinden.

Die Aluminiumbleche 20 - 24 sind mittels Lotschichten 30 bzw. 32 miteinander verbunden, wobei zwischen zwei benachbarten Aluminiumblechen jeweils eine Lotschicht liegt. Die Lotschicht befindet sich insbesondere dort, wo die Aluminiumbleche auch aufeinander stoßen, wobei an den Ausnehmungen 50, 52 auch keine Lötmasse bzw. auch keine Lotschicht vorgesehen sein kann. Innerhalb der Ausnehmungen 50, 52 können sich Turbulatoren 40 befinden, die wie dargestellt aus gewelltem Blech ausgebildet sind. Diese sind über einzelne Lotschichtabschnitte 34 mit den angrenzenden Aluminiumblechen 20, 24 verbunden. Die Turbulatoren 50, 52 sind jedoch optional und können auch weggelassen werden. Die Ausnehmungen 50, 52 erstrecken sich durch die gesamte Dicke des zwischenliegenden Aluminiumblechs 22 hindurch. Dadurch bilden die Ausnehmungen 50, 52 gleichermaßen jeweils einen Kühlkanal (oder Kühlkanalabschnitt eines gemeinsamen Kühlkanals), der von den Blechen 20, 24 abgeschlossen ist, zwischen denen das Blech 22 mit den Ausnehmungen liegt.

An einer Außenseite der gestapelten Aluminiumbleche, insbesondere an einer Hauptoberfläche eines außenliegenden Aluminiumblechs 20, 24, welches von den Ausnehmungen 50, 52 abgewandt ist, befindet sich eine Lotvermittlungsschicht 90, welche mit dem Aluminiumblech 24 verbunden ist. Die Lotschichten 30 - 34 sind Hartlotschichten und können in einem gemeinsamen Schmelzprozess innerhalb eines Ofens erzeugt werden. Die Lotschicht 36 wird weggelassen da die Lotvermittlungsschicht 90 durch Abscheidungs- oder Beschichtungsverfahren hergestellt ist, und zwar als galvanische Schicht oder als aufgedampfte Schicht. In diesem Fall grenzt die Lotvermittlungsschicht 90 direkt an das Aluminiumblech (bzw. an den Aluminiumkühlkörper) an.

Die Lotvermittlungsschicht 90 bildet eine Befestigungsfläche 92, die den Aluminiumblechen 20 - 24 abgewandt ist. Diese Befestigungsfläche 92 wird gebildet von einer Oberseite der Lotvermittlungsschicht 90 und insbesondere von einer mit einer Lotschicht 70 versehenen Oberfläche der Lotvermittlungsschicht 90. Die Lotschicht 70 ist insbesondere aus Weichlot und dient insbesondere der einfacheren weiteren Bestückung. Auf die Befestigungsfläche können zu kühlende elektronische oder elektrische Komponenten befestigt werden.

Die Figur 1 zeigt neben dem erfindungsgemäßen Kühlkörper 10 eine bestückte Leiterplatte 60, die sich auf der Befestigungsfläche 92 befindet. Somit zeigt die Figur 1 neben dem erfindungsgemäßen Kühlkörper 10 auch eine Leistungsschaltung, die den Kühlkörper 10 umfasst und die ferner die Leistungsschaltung ausbildet. Die Leiterplatte 60 ist eine beidseitig beschichtete Leiterplatte mit einer ersten Leiterschicht 62 und einer zweiten Leiterschicht 64. Die erste Leiterschicht 62 ist über die Weichlotschicht 70 mit der Lotvermittlungsschicht 70 verbunden, so dass die Leiterplatte 60 über die erste Leiterschicht 62 mit der Befestigungsfläche des Kühlkörpers 10 verbunden ist. Die entgegengesetzte, zweite Leiterschicht 62 dient zur Montage eines Halbleiters 80, der stellvertretend auch für andere elektrische oder elektronische Bauteile steht, insbesondere Leistungsbauteile.

Eine Lotschicht 72, die ebenso wie die Schicht 70 als Weichlotschicht ausgebildet ist, verbindet den Halbleiter 80 mit der zweiten Leiterschicht 64, die den Kühlkörper 10 abgewandt ist. Der Halbleiter 80 ist ein ungehäuster Halbleiter, etwa ein Transistor, insbesondere ein IGBT oder ein MOSFET. Der Halbleiter 80 steht nur beispielhaft für eine Vielzahl von Bauteilen, die auf der Leiterplatte 60 montiert sein können.

Zur besseren Darstellung wurde in Figur 1 die Leiterplatte 60 schmaler als das Nickel-Blechstück dargestellt, wobei in weiteren Ausführungsformen die Leiterplatte seitlich über die Lotschicht und auch über den Kühlkörper 10 hinausgehen kann. Hierbei sind insbesondere Leistungshalbleiter oder Leistungsbauteile, die abzuführende Wärme erzeugen, vorzugsweise über der Befestigungsfläche 92 angeordnet, so dass der Wärmeleitpfad für die abzuführende Wärme kurz bleibt.

Weiterhin kann der Kühlkörper 10 nicht nur einseitig eine Lotvermittlungsschicht 90 und somit eine Befestigungsfläche 92 aufweisen, sondern kann auch beidseitig mit Lotvermittlungsschichten versehen sein. Hierbei ist beispielhaft die optionale Lotvermittlungsschicht 90' dargestellt, welche sich gegenüber der Lotvermittlungsschicht 90 auf entgegengesetzter Seite des Aluminiumkörpers (gebildet durch die Aluminiumschichten 20 - 24) befindet. Diese zweite Lotvermittlungsschicht 90' weist eine weitere Befestigungsfläche 92' auf, an der Bauteile oder Leiterplatten befestigt werden können, um deren Wärme abzuführen. Die Lotvermittlungsschicht 90' ist wie die Lotvermittlungsschicht 90 mittels einer Hartlotschicht 36' mit dem Aluminiumkühlkörper (d.h. mit den Aluminiumblechen) verbunden. Dies ist allerdings nur eine Möglichkeit von vielen. Beispielsweise kann die Lotvermittlungsschicht 90' wie die Lotvermittlungsschicht 90 unmittelbar stoffschlüssig mit dem Aluminiumkörper bzw. mit den Aluminiumblechen verbunden sein, etwa als aufgalvanisierte oder aufgedampfte Schicht.

Wie bereits bemerkt, wird der Aluminiumkühlkörper von den Aluminiumblechen 20, 22 und 24 sowie den dazwischenliegenden Lotschichten 30 und 32 gebildet, ggf. inklusive der Turbulatoren 40.

Neben internen Kühlkanälen kann der Aluminiumkühlkörper auch Kühlfinnen aufweisen, insbesondere an der Oberfläche des Aluminiumkühlkörpers, so dass alternativ oder zusätzlich Wärme über die Oberfläche des Kühlkörpers (und nicht nur über die Kühlkanäle) abgeführt werden kann.

### Bezugszeichenliste

- 10: Kühlvorrichtung
- 20, 22, 24: Aluminiumbleche
- 26: Aluminiumkühlkörper
- 30, 32, 36: Lotschichten, insbesondere Hartlotschichten
- 34: Hartlotschichten zur Befestigung der Turbulatoren
- 40: Turbulatoren
- 50, 52: Ausnehmungen in Aluminiumblech bzw. in Aluminiumkühlkörper 26
- 60: Leiterplatte
- 62, 64: Leiterschichten der Leiterplatte 60
- 70, 72: Lotschichten, insbesondere Weichlotschichten
- 80: Halbleiter, vorzugsweise ungehäust
- 90, 90': Lotvermittlungsschicht
- 92, 92': Befestigungsfläche

## Patentansprüche

1. Kühlvorrichtung (10), die einen Aluminiumkühlkörper (26) und mindestens eine Lotvermittlungsschicht (90, 90') aufweist, welche stoffschlüssig und unmittelbar auf dem Aluminiumkühlkörper (26) befestigt ist, wobei die Kühlvorrichtung (10) eine Befestigungsfläche (92, 92') zur Befestigung und zur Wärmeaufnahme aufweist, die von einer Seite der Lotvermittlungsschicht (90) ausgebildet wird, die dem Aluminiumkühlkörper (26) abgewandt ist, und wobei der Aluminiumkühlkörper (26) aus mehreren übereinander gestapelten und miteinander verbundenen Aluminiumblechen (20, 22, 24) ausgebildet ist, wobei zumindest ein Aluminiumblech (22) Ausnehmungen (50) aufweist, die einen Kühlkanal bilden, der von zumindest einem der Aluminiumbleche (20, 24) abgedeckt ist, wobei die mindestens eine Lotvermittlungsschicht (90') auf dem Aluminiumkühlkörper (26) aufgedampft oder mittels galvanischer Abscheidung aufgebracht ist.

2. Kühlvorrichtung nach Anspruch 1, wobei die Aluminiumbleche mittels Lotschichten (30, 32) miteinander verbunden sind.

3. Kühlvorrichtung nach Anspruch 1 oder 2, wobei die Aluminiumbleche (20 - 24) gewalzte Aluminiumbleche sind, die mittels Hartlot verlötbar sind.

4. Kühlvorrichtung nach einem der vorangehenden Ansprüche, wobei die Lotvermittlungsschicht (90, 90') als Nickelschicht ausgebildet ist und einen Massenanteil von Nickel von mindestens 70%, 85% und vorzugsweise mindestens 95%, 98% oder 99% Nickel aufweist.

5. Kühlvorrichtung nach einem der vorangehenden Ansprüche, wobei die Lotvermittlungsschicht (90, 90') eine Dicke von nicht mehr als 150, 100 oder 50 µm aufweist.

6. Verfahren zur Herstellung einer Kühlvorrichtung (10) nach einem der vorangehenden Ansprüche, umfassend:
- Stapeln der Aluminiumbleche (20, 22, 24) zur Ausbildung eines Aluminiumkühlkörpers, von denen mindestens eines Ausnehmungen zu Ausbildung eines Kühlkanals aufweist;
- Verbinden der gestapelten Aluminiumbleche (20, 22, 24) miteinander zur Ausbildung des Aluminiumkühlkörpers und
- Anordnen der Lotvermittlungsschicht (90, 90') auf zumindest einem der Aluminiumbleche (24), das eine Außenseite des Aluminiumkühlkörpers (26) bildet, durch unmittelbares stoffschlüssiges Aufbringen auf zumindest eines der Aluminiumbleche vor oder nach den Schritten des Stapelns und des Verbindens;
- wobei das stoffschlüssige Aufbringen durch Aufdampfen oder galvanische Abscheidung erfolgt.

7. Verfahren nach Anspruch 6, wobei vor dem Stapeln zumindest eines der Aluminiumbleche (22) gestanzt wird, um durch das Stapeln mittels der umgebenden Aluminiumbleche (20, 24) einen Kühlkanal auszubilden.

8. Leistungsschaltung mit einem Kühlkörper (10) nach einem der Ansprüche 1-5, wobei die Leistungsschaltung ferner eine Leiterplatte (60) mit beidseitiger Leiterschicht (62, 64) aufweist, die über eine Lotschicht (70) mit der Lotvermittlungsschicht (90) verbunden ist, und wobei die Leistungsschaltung ferner mindestens einen Halbleiter (80) aufweist, der auf der Seite der Leiterplatte (60) auf der Leiterplatte (60) montiert ist, die der Lotvermittlungsschicht (90) abgewandt ist.

9. Leistungsschaltung nach Anspruch 8, wobei der Halbleiter (80) ein Leistungshalbleiter in Form eines ungehäusten Halbleiters ist, der mittels einer Weichlotschicht (62) auf der Leiterplatte befestigt ist.

## Claims

1. Cooling device (10) comprising an aluminium heat sink (26) and at least one solder mediation layer (90, 90'), which is secured cohesively and directly on the aluminium heat sink (26), wherein the cooling device (10) comprises a securing surface (92, 92') for securing and for heat absorption, said securing surface being formed by a side of the solder mediation layer (90) which faces away from the aluminium heat sink (26), and wherein the aluminium heat sink (26) is formed from a plurality of aluminium sheets (20, 22, 24) which are stacked one above another and are connected to one another, wherein at least one aluminium sheet (22) comprises cutouts (50) which form a cooling channel covered by at least one of the aluminium sheets (20, 24), wherein the at least one solder mediation layer (90') is applied by vapour deposition or by means of electrodeposition on the aluminium heat sink (26).

2. Cooling device according to Claim 1, wherein the aluminium sheets are connected to one another by means of solder layers (30, 32).

3. Cooling device according to Claim 1 or 2, wherein the aluminium sheets (20 - 24) are rolled aluminium sheets which are solderable by means of hard solder.

4. Cooling device according to any of the preceding claims, wherein the solder mediation layer (90, 90') is formed as a nickel layer and has a proportion by mass of nickel of at least 70%, 85% and preferably at least 95%, 98% or 99% nickel.

5. Cooling device according to any of the preceding claims, wherein the solder mediation layer (90, 90') has a thickness of not more than 150, 100 or 50 µm.

6. Method for producing a cooling device (10) according to any of the preceding claims, comprising:
- stacking the aluminium sheets (20, 22, 24) in order to form an aluminium heat sink, at least one of said aluminium sheets having cutouts for forming a cooling channel;
- connecting the stacked aluminium sheets (20, 22, 24) to one another in order to form the aluminium heat sink, and
- arranging the solder mediation layer (90, 90') on at least one of the aluminium sheets (24), which forms an outer side of the aluminium heat sink (26), by direct cohesive application on at least one of the aluminium sheets before or after the steps of stacking and connecting;
- wherein the cohesive application is carried out by vapour deposition or electrodeposition.

7. Method according to Claim 6, wherein before stacking at least one of the aluminium sheets (22) is stamped in order to form a cooling channel as a result of the stacking by means of the surrounding aluminium sheets (20, 24).

8. Power circuit comprising a heat sink (10) according to any of Claims 1-5, wherein the power circuit furthermore comprises a circuit board (60) having a conductor layer (62, 64) on both sides, which is connected to the solder mediation layer (90) via a solder layer (70), and wherein the power circuit furthermore comprises at least one semiconductor (80) which is mounted on the circuit board (60) on the side of the circuit board (60) which faces away from the solder mediation layer (90).

9. Power circuit according to Claim 8, wherein the semiconductor (80) is a power semiconductor in the form of an unpackaged semiconductor which is secured on the circuit board by means of a soft solder layer (62).

## Revendications

1. Dispositif de refroidissement (10), qui possède un dissipateur thermique en aluminium (26) et au moins une couche de liaison de brasage (90, 90') qui est fixée par liaison de matière et directement au dissipateur thermique en aluminium (26), le dispositif de refroidissement (10) possédant une surface de fixation (92, 92') destinée à la fixation et servant à l'absorption de chaleur, laquelle est formée par un côté de la couche de liaison de brasage (90) qui est orienté à l'opposé du dissipateur thermique en aluminium (26), et le dissipateur thermique en aluminium (26) étant formé par plusieurs tôles en aluminium (20, 22, 24) empilées les unes au-dessus des autres et reliées entre elles, au moins une tôle en aluminium (22) possédant des creux (50) qui forment un canal de refroidissement, lequel est recouvert par au moins l'une des tôles en aluminium (20, 24), l'au moins une couche de liaison de brasage (90') étant métallisée sous vide sur le dissipateur thermique en aluminium (26) ou étant appliquée au moyen d'une précipitation galvanique.

2. Dispositif de refroidissement selon la revendication 1, les tôles en aluminium étant reliées entre elles au moyen de couches de brasure (30, 32).

3. Dispositif de refroidissement selon la revendication 1 ou 2, les tôles en aluminium (20 - 24) étant des tôles en aluminium laminées qui peuvent être brasées entre elles au moyen d'un métal d'apport de brasage fort.

4. Dispositif de refroidissement selon l'une des revendications précédentes, la couche de liaison de brasage (90, 90') étant réalisée sous la forme d'une couche de nickel et possédant une part massique de nickel d'au moins 70 %, de 85 % et de préférence d'au moins 95 %, de 98 % ou de 99 % de nickel.

5. Dispositif de refroidissement selon l'une des revendications précédentes, la couche de liaison de brasage (90, 90') possédant une épaisseur maximale de 150, 100 ou 50 µm.

6. Procédé de fabrication d'un dispositif de refroidissement (10) selon l'une des revendications précédentes, comprenant :
- l'empilement des tôles en aluminium (20, 22, 24) en vue de former un dissipateur thermique en aluminium, parmi lesquelles au moins l'une possède des creux en vue de former un canal de refroidissement ;
- la liaison des tôles en aluminium (20, 22, 24) empilées les unes avec les autres en vue de former le dissipateur thermique en aluminium, et
- la disposition de la couche de liaison de brasage (90, 90') sur au moins l'une des tôles en aluminium (24), qui forme un côté extérieur du dissipateur thermique en aluminium (26), par application directe par liaison de matière sur au moins l'une des tôles en aluminium avant ou après les étapes d'empilement et de liaison ;
- l'application par liaison de matière s'effectuant par métallisation sous vide ou par précipitation galvanique.

7. Procédé selon la revendication 6, au moins l'une des tôles en aluminium (22) étant estampée avant l'empilement en vue de former un canal de refroidissement par l'empilement au moyen des tôles en aluminium (20, 24) environnantes.

8. Circuit de puissance comprenant un dissipateur thermique (10) selon l'une des revendications 1 à 5, le circuit de puissance possédant en outre un circuit imprimé (60) doté d'une couche conductrice (62, 64) sur les deux faces, laquelle est reliée à la couche de liaison de brasage (90) par le biais d'une couche de brasure (70), et le circuit de puissance possédant en outre au moins un semi-conducteur (80) qui est monté sur le circuit imprimé (60) sur la face du circuit imprimé (60) qui est à l'opposé de la couche de liaison de brasage (90).

9. Circuit de puissance selon la revendication 8, le semi-conducteur (80) étant un semi-conducteur de puissance sous la forme d'un semi-conducteur sans boîtier qui est fixé au circuit imprimé au moyen d'une couche de brasage tendre (62).
